# EUROPEAN PATENT APPLICATION

(11) **EP 2 492 982 A2**
(43) Date of publication of application: **29.08.2012**
(21) Application number: 12156525.3
(22) Date of filing: 22.02.2012
(51) Int. Cl.: H01L 33/62, H01L 33/64

(54) **Light emitting device package**

(30) Priority: 22.02.2011 KR 20110015483
(71) Applicant: Samsung LED Co., Ltd., Yongi-City, Gyeonggi-Do (KR)
(72) Inventor: Lee, Won Joon, Seoul (KR); Han, Seong Yeon, Gwangju (KR); Kim, Yong Seok, Seoul (KR); Kwon, Jae Wook, Seoul (KR); Choi, Sung A, Gyeonggi-do (KR); Choi, Myoung Soo, Seoul (KR)
(74) Representative: Grünecker, Kinkeldey, Stockmair & Schwanhäusser

(57) **Abstract**

There is provided a light emitting device package, including: a package body; a first lead frame coupled to the package body and including a first recess having an exposed side, the first recess having a chip mounting area formed to be downwardly recessed therein, wherein at least a part of a bottom surface of the chip mounting area is exposed to a bottom surface of the package body; a second lead frame coupled to the package body so as to have a predetermined distance from the first lead frame and including a second recess having an exposed side opposed to the exposed side of the first recess; and at least one light emitting device mounted on the chip mounting area of the first lead frame and electrically connected with the first and second lead frames.

## Description

### CROSS-REFERENCE TO RELATED APPLICATIONS

This application claims the priority of Korean Patent Application No.10-2011-0015483 filed on February 22, 2011, in the Korean Intellectual Property Office, the disclosure of which is incorporated herein by reference.

### BACKGROUND OF THE INVENTION

### Field of the Invention

The present invention relates to a light emitting device package, and more particularly, to a light emitting device package having a function capable of preventing degradation of a resin material and superior heat radiating properties and allowing for an improvement of optical efficiency.

### Description of the Related Art

In general, a light emitting diode (LED), a kind of semiconductor light emitting device, is a semiconductor device capable of emitting light having various colors due to the recombination of electrons and electron holes at the junction between a p-type semiconductor and an n-type semiconductor, when current is applied.

The light emitting diode (LED) is advantageous in that it is eco-friendly, allows for a high speed response at a response rate of several nanoseconds to thereby be effective in a video signal stream, allows for impulsive driving, has color reproducibility of 100% or more, and is capable of optically changing brightness, color temperature or the like by adjusting the quantity of light of a red, a green, or a blue light emitting diode chip.

In recent years, a light emitting diode using a nitride semiconductor has been used as a white light source and has been employed in various fields, such as a keypad, a backlight, a traffic signal, a guiding light in an airport runway, a lighting bulb or the like. As the use of a light emitting diode chip is varied in this manner, the importance of a light emitting device package has come to prominence.

In particular, demands for a light emitting device package efficiently emitting heat generated from a light emitting device to the outside have increased. This is because a resin package part sealing a light emitting device and an injected resin forming a package body may be deteriorated in the case in which heat emitted from the light emitting device is not effectively emitted to the outside. This deterioration may be more serious in a high-output light emitting device.

In addition, in a general package structure, a lead frame may be molded in a package body made of an injected resin, and the inner wall of the package body made of the injected resin may act as a reflective film.

However, since the injected resin may have characteristics vulnerable to light of a short wavelength or to heat, the chemical properties of the injected resin may be changed and characteristics thereof may be altered by the light of a short wavelength, such as ultraviolet light.

That is, in the general package structure, light generated from a light emitting device may cause the inner wall made of a resin to be deteriorated and discolored while being irradiated directly on the resin inner wall of the package structure, whereby reflection effects may be degraded to cause reliability in the light emitting device to be lowered.

Meanwhile, since the degradation of a resin surface may be relatively accelerated as the output from a light source is increased, a package structure applicable to a high-output light emitting device has been required.

### SUMMARY OF THE INVENTION

An aspect of the present invention provides a light emitting device package having improved reliability by effectively emitting heat generated from a light emitting device.

An aspect of the present invention also provides a light emitting device package having improved light efficiency, by preventing the degradation and discoloration of a resin due to sidelight emitted from the light emitting device to thereby allow for an increase in light reflexibility.

An aspect of the present invention also provides a light emitting device package capable of preventing the occurrence of an electrical failure caused by a wire being pressed-down to thereby come into contact with a lead frame during the sealing of a resin package part.

According to an aspect of the present invention, there is provided a light emitting device package, including a package body; a first lead frame coupled to the package body and including a first recess having an exposed side, the first recess having a chip mounting area formed to be downwardly recessed therein, wherein at least a part of a bottom surface of the chip mounting area is exposed to a bottom surface of the package body, a second lead frame coupled to the package body so as to have a predetermined distance from the first lead frame and including a second recess having an exposed side opposed to the exposed side of the first recess; and at least one light emitting device mounted on the chip mounting area of the first lead frame and electrically connected with the first and second lead frames.

The chip mounting area of the first lead frame may have a side wall formed therein, as a reflective surface.

The side wall of the chip mounting area may be formed to be inclined.

The side walls of the first and second lead frames may be bent upwardly from bottom surfaces of the first and second recesses to form reflective surfaces.

The side walls of the first and second lead frames are bent upwardly from bottom surfaces of the first and second recesses to form stepped portions, the side walls forming inclined reflective surfaces.

At least a portion of the stepped parts may be formed to be exposed from the package body.

The chip mouting area may have a predetermined height so as to prevent light emitted from a side surface of the light emitting device from being irradiated on an inner wall of the package body.

The first and second recesses may have a predetermined height so as to prevent light emitted from a side surface of the light emitting device from being irradiated on an inner wall of the package body.

The first and second lead frames may be electrically isolated by an insulating part of the package body, formed therebetween.

The light emitting device package may further include a wire electrically connecting a bottom surface of the second recess and the light emitting device.

The top surface of the second recess has a zener diode mounted thereon.

The light emitting device package may further include a wire electrically connecting the zener diode and a bottom surface of the first recess.

The light emitting device package may further include a resin package part provided in the chip mounting area and the first and second recesses.

The resin package part may include a fluoroscent material converting a wavelength of light emitted from the light emitting device.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a schematic perspective view of a light emitting device package according to an embodiment of the present invention;
FIG. 2 is a plan view of the light emitting device package shown in FIG. 1;
FIG. 3 is a bottom view of the light emitting device package shown in FIG. 1;
FIG. 4 is a side cross-sectional view of the light emitting device package shown in FIG. 1; and
FIG. 5 is a front cross-sectional view of the light emitting device package shown in FIG. 1.

### DETAILED DESCRIPTION OF THE INVENTION

Embodiments of the present invention will now be described in detail with reference to the accompanying drawings.

The invention may, however, be embodied in many different forms and should not be construed as being limited to the embodiments set forth herein. Rather, these embodiments are provided so that this disclosure will be thorough and complete, and will fully convey the scope of the invention to those skilled in the art.

In the drawings, the shapes and sizes of components may be exaggerated for clarity. The same or equivalent elements are referred to by the same reference numerals throughout the specification.

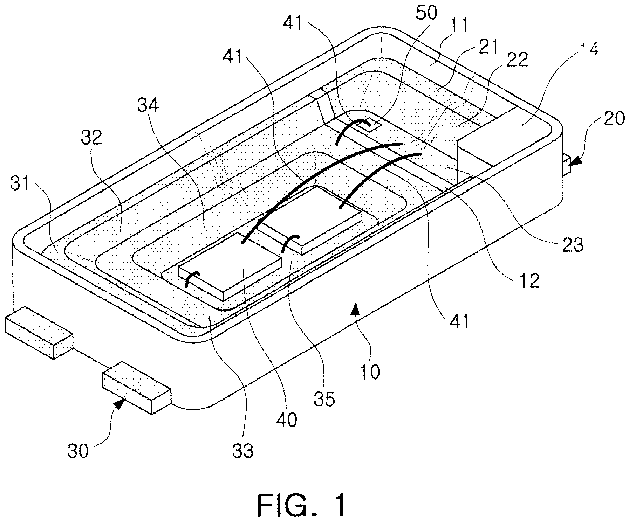

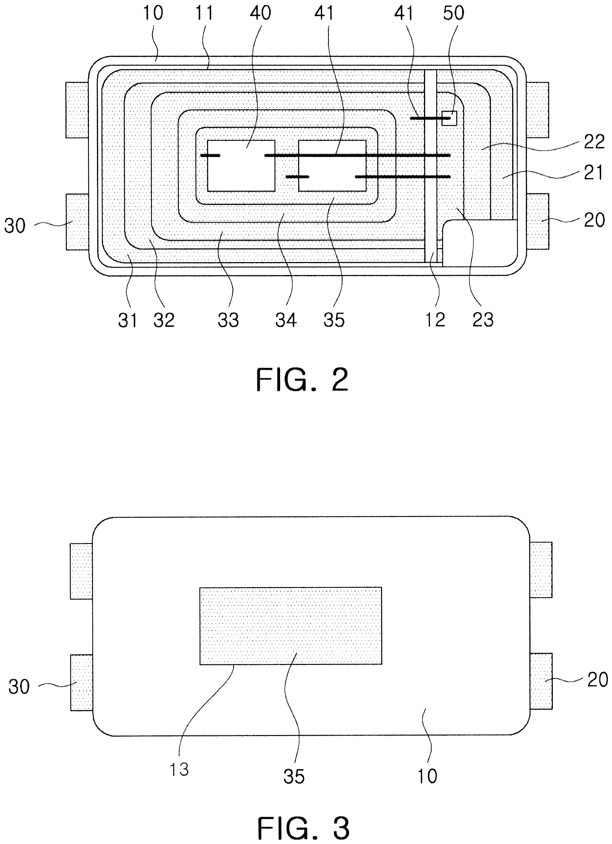

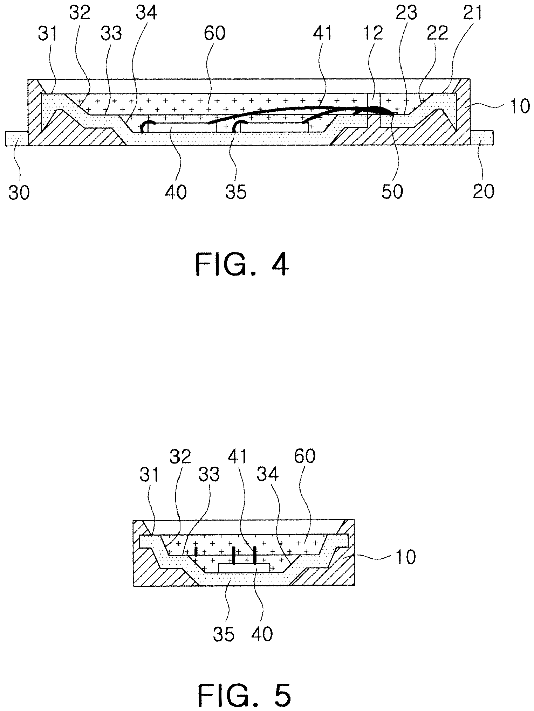

Referring to FIGS. 1 through 5, a light emitting device package according to an embodiment of the present invention may include a package body 10, a first lead frame 30 and a second lead frame 20 coupled to an inner wall of the package body 10, and light emitting devices 40 disposed on the first lead frame 30.

The first and second lead frames 30 and 20 may have a first recess and a second recess, respectively. The first and second recesses each have an exposed side, and the exposed side of the first recess and the exposed side of the second recess may be disposed to be opposed to each other. In this case, a bottom surface 23 of the second recess formed in the second lead frame 20 may be used as a wire bonding area.

The package body 10 may be made of an electrical insulting material. Further, the package body 10 may have an insulating part 12 formed between the first and second lead frames 20 and 30, the insulating part 12 forming a coplanar surface with bottom surfaces 33 and 23 of the first and second recess, such that the leading edge portions of the first and second recesses, opposed to each other, may be electrically isolated.

In addition, an aperture 13, coupled to the outer side wall of a concave part (to be described later) formed in the first lead frame 30 and allowing at least a part of the bottom surface of the first lead frame 30 to be exposed downwardly to the bottom surface of the package body 10, may be formed in the bottom surface of the package body 10.

In addition, some corners of the package body 10 may be provided with a cover part 14 covering a part of the second lead frame 20 so as to enhance coupling force with the second lead frame 20.

The light emitting device package may have a down-set structure, in which the first recess of the first lead frame 30 may be provided with a concave part formed to be downwardly recessed as a chip mounting area, and at least a part of a bottom surface 35 of the concave part may exposed to the bottom surface of the package body 10 through the aperture 13 formed in the bottom surface of the package body 10 to thereby allow for the radiation of heat from the light emitting devices and the communication of an electrical signal.

In this case, as much as possible of the bottom surface 35 of the concave part may be exposed in order to increase the emission of heat.

That is, the lead frame 30 may have the first recess having an exposed side, and the bottom surface 33 the first recess may be provided with the concave part as a chip mounting area. In this case, a width, a length, and a depth of the concave part are adjusted corresponding to the size of the light emitting devices 40. The light emitting devices 40 may be mounted on the bottom surface 33 of the concave part.

In this case, a side wall 34 of the concave part may be vertically formed; however, it may be formed to be inclined so as to effectively reflect light of the light emitting devices 40 in the front direction.

The light emitting device 40 according to the embodiment of the present invention may not be particularly limited, as long as it may be used as a light source. However, a light emitting diode may be employed as the light emitting device 40, in a view of the miniaturization and high efficiency of the light source.

The light emitting diode, a light source generating light by the application of voltage, may emit light having three colors, such as red, green, and blue and exhibit white light through the mixture thereof. The light emitting diode may generate light having a desired specific color by mounting of respective colored light emitting diode chips and differentially applying voltage to each of the light emitting diode chips.

Meanwhile, the white light may be also generated by a light emitting diode chip having a single color, for example, a blue light emitting diode chip, and a fluorescent substance having a specific color. In this case, the generation of white light may be caused by the mixture of the respective unique colors of light generated from the light emitting diode chips during the penetration of the light through the fluorescent substance.

The light emitting device 40 may not be limited to the light emitting diode, and may be mounted on the bottom surface 35 of the concave part of the first recess formed in the first lead frame 30. The embodiment of the present invention illustrates two light emitting devices 40 mounted on the bottom surface 35 of the concave part in such a manner as to be spaced apart from each other. However, the light emitting device 40 may be singularly mounted or three or more light emitting devices 40 may be mounted.

The respective light emitting devices 40 mounted on the bottom surface 35 of the concave part of the first recess formed in the first lead frame 30 may be electrically connected with each of the first and second lead frames 30 and 20 by conductive wires 41.

According to the electrode disposition of the light emitting devices 40, in the case of so-called flip chip bonding, the second lead frame 20 and the light emitting devices 40 may be electrically connected via the wires 40, and the first lead frame 30 may be directly electrically connected to the light emitting devices 40, without the wires 40.

In addition, the light emitting devices 40 may be connected to the bottom surface 33 of the first recess formed in the first lead frame 30 via the wires 40; however, the light emitting devices 40 may be connected to the bottom surface of the concave part in order to allow for the minimum length of the wires 41.

For the same reason, the light emitting devices 40 and the bottom surface 23 of the second recess formed in the second lead frames 20 may be connected via the wires 41.

In general, a light emitting device may be a cube light source, rather than a point light source, and thus emit light from respective surfaces thereof.

Particularly, since a great amount of light may be emitted from the side surfaces of the light emitting device, altering the path of light through the formation of a reflective surface may be required in order to allow light generated from the side surfaces to be directed upwardly.

To this end, in the embodiment of the preset invention, the first and second lead frames 30 and 20 may include the concave part as a chip mounting area having a predetermined height, the first and second recesses formed upwardly of the concave part, and side walls 32 and 22 configured as reflective surfaces, such that light emitted from the light emitting devices 40 may be reflected on the side walls 32 and 22 to change the path thereof upwardly.

That is, the first and second lead frames 30 and 20 may be formed of the bottom surfaces 33 and 23 of the first and second recesses, and the side walls 32 and 22 bent from the bottom surfaces 33 and 23 of the first and second recesses to be inclined upwardly. As the first and second lead frames 30 and 20 may be made of a metallic material, the side walls 32 and 22 may be used as the reflective surfaces of light emitted from the light emitting devices 40.

In this case, the side walls 32 and 22 of the first and second lead frames 30 and 20 may be vertical; however, the side walls 32 and 22 of the first and second lead frames 30 and 20 may be inclined so as to effectively reflect light emitted from the light emitting devices 40 in the front direction.

Meanwhile, when light emitted from the light emitting devices 40 is irradiated on an inner wall 11 of the package body 10, the inner wall being made of a resin, the inner wall 11 may be discolored by the short wavelength of light and the reliability thereof may be degraded. In the embodiment of the present invention, through the reflection effects of the first and second recesses forming the first and second lead frames 30 and 20, light emitted from the light emitting devices 40 irradiated directly on the inner wall 11 of the package body 10 may be prevented or minimized.

At least one of the side walls 32 and 22 of the first and second recesses formed in the first and second lead frames 30 and 20 may be bent upwardly from the bottom surface 33 of the first recess or the bottom surface 23 of the second recess to form a first stepped part 31 or a second stepped part 21. The first stepped part 31 or the second stepped part 21 may include an inclined surface extended from the bottom surface 33 of the first recess or the bottom surface 23 of the second recess, and a planar surface extended from the inclined surface.

The irradiating of light generated from the light emitting device 40 onto the inner wall 11 of the package body 10 may be more easily prevented by the first and second stepped parts 31 and 21. Since the injection height of a resin package part, to be described later, may be defined by the height of the first and second stepped parts 31 and 21, the filling of the resin package part may be facilitated.

In this case, the first and second stepped parts 31 and 21 may have a partial area buried in the package body 10, whereby coupling force between the first and second lead frames 30 and 20 and the package body 10 may be increased.

Further, exposed portions of the first and second stepped parts 31 and 21 may be extended outwardly of the package body 10, the exposed portions being opposed to the exposed sides of the first and second recesses, respectively.

In the embodiment of the present invention, the exposed portions of the first and second stepped parts 31 and 21 may be formed to be coplanar with the bottom surface 35 of the concave part as the first and second stepped parts 31 and 21 may be further bent from the planar surfaces thereof. However, the structure of the stepped parts may be appropriately changed according to the size and shape of a product.

A light-transmitting resin package part 60 sealing the light emitting device 40 may be formed within the package body 10, that is, the concave part and the first and second recesses, in order to protect the light emitting devices 40 and realize the refractive index matching between a material constituting the light emitting devices 40 and the outside to thereby improve external light extraction efficiency.

The resin package part 60 may include dispersed fluorescent materials to convert the wavelength of light emitted from the light emitting devices 40, for example, to absorb light emitted from the light emitting device 40 to thereby convert the absorbed light into visible light.

For example, transparent epoxy, silicon or the like may be used in the resin package part 60.

At this time, during the forming of the resin package part 60, the wires 41 may be pressed-down and come into contact with a component of the lead frames, such as the concave part, to thereby cause electrical failure, such as the occurrence of shorts. However, in the embodiment of the present invention, as a recessed portion may be formed to have a two-stepped layer structure, the wires 41 may be mounted on an upper space and a lower space of the two-stepped layer structure, whereby defects caused by the wires being pressed down may be minimized.

In this manner, in the light emitting device package according to the embodiment of the present invention, the first and second lead frames may have the concave part and the first and second recesses formed therein, whereby the degradation of a resin forming the package body 10 due to the irradiation of light generated from the light emitting devices 40 may be lowered. Further, the light emitting device package may have a down-set structure allowing a part of the concave part formed in the first lead frame to be exposed to the bottom surface of the package body 10, whereby the emission efficiency of heat transferred from the light emitting devices 40 may be improved to allow for the maximization of the reliability of a product.

In the light emitting device package described above, the second lead frame 20 may further include a zener diode 50 for a constant voltage operation.

That is, the zener diode 50 may be mounted on the bottom surface 23 of the second recess formed in the second lead frame 20, and the wire 41 connected to the zener diode 50 may be connected to the bottom surface 33 of the first recess, whereby the zener diode 50 and the bottom surface 33 of the first recess may be electrically connected.

Consequently, the mounting surface of the zener diode 50 may be coplanar with the bottom surface 33 of the first recess, thereby not generating a stepped part, whereby the length of the wire 41 may be minimized.

As set forth above, according to an embodiment of the invention, since the light emitting device may be mounted on the chip mounting area exposed to the bottom surface of the package body, heat transferred from the light emitting device may be effectively emitted and the degradation of an injected resin may be minimized to thereby allow for an improvement in the reliability of a product.

In addition, since sidelight emitted from the light emitting device may not reach to the inner wall of the package body due to being reflected from the side walls of the chip mounting area and the recesses formed in a two-stepped manner and made of a metallic material, discoloration of the inner wall of the package body may be prevented and at the same time, light reflexibility may be increased to thereby allow for the improvement in the light-extraction efficiency of the package and prevent the distortion of the sidelight.

Furthermore, the maximum upper and lower spaces between the sealed top portion of the lead frames and the light emitting device may be secured during the boding of wires, whereby the occurrence of electrical failure, such as shorts caused by the wires being pressed-down to thereby come into contact with the surfaces of the lead frames.

While the present invention has been shown and described in connection with the embodiments, it will be apparent to those skilled in the art that modifications and variations can be made without departing from the spirit and scope of the invention as defined by the appended claims.

## Claims

1. A light emitting device package, comprising:
a package body;
a first lead frame coupled to the package body and including a first recess having an exposed side, the first recess having a chip mounting area formed to be downwardly recessed therein, wherein at least a part of a bottom surface of the chip mounting area is exposed to a bottom surface of the package body,
a second lead frame coupled to the package body so as to have a predetermined distance from the first lead frame and including a second recess having an exposed side opposed to the exposed side of the first recess; and
at least one light emitting device mounted on the chip mounting area of the first lead frame and electrically connected with the first and second lead frames.

2. The light emitting device package of claim 1, wherein the chip mounting area of the first lead frame has a side wall formed therein, as a reflective surface.

3. The light emitting device package of claim 2, wherein the side wall of the chip mounting area is formed to be inclined.

4. The light emitting device package of claim 1 or 2, wherein side walls of the first and second lead frames are bent upwardly from bottom surfaces of the first and second recesses to form reflective surfaces.

5. The light emitting device package of claim 1 or 2, wherein side walls of the first and second lead frames are bent upwardly from bottom surfaces of the first and second recesses to form stepped portions, and the side walls form inclined reflective surfaces.

6. The light emitting device package of claim 5, wherein at least a portion of the stepped parts is exposed from the package body.

7. The light emitting device package of claim 1 or 2, wherein the chip mouting area has a predetermined height so as to prevent light emitted from a side surface of the light emitting device from being irradiated onto an inner wall of the package body.

8. The light emitting device package of claim 1 or 2, wherein the first and second recesses have a predetermined height so as to prevent light emitted from a side surface of the light emitting device from being irradiated onto an inner wall of the package body.

9. The light emitting device package of claim 1 or 2, wherein the first and second lead frames are electrically isolated by an insulating part of the package body, formed therebetween.

10. The light emitting device package of claim 1 or 2, further comprising a wire electrically connecting a bottom surface of the second recess and the light emitting device.

11. The light emitting device package of claim 1 or 2, wherein a top surface of the second recess has a zener diode mounted thereon.

12. The light emitting device package of claim 11, further comprising a wire electrically connecting the zener diode and a bottom surface of the first recess.

13. The light emitting device package of claim 1 or 2, further comprising a resin package part provided in the chip mounting area and the first and second recesses.

14. The light emitting device package of claim 13, wherein the resin package part includes a fluoroscent material converting a wavelength of light emitted from the light emitting device.
